# EUROPÄISCHE PATENTSCHRIFT

(11) **EP 2 363 928 B1**
(45) Veröffentlichungstag und Bekanntmachung des Hinweises auf die Patenterteilung: **28.03.2012**
(21) Anmeldenummer: 10002153.4
(22) Anmeldetag: 03.03.2010
(51) Int. Cl.: H01S 5/022, H01S 5/024, H01S 5/065

(54) **Laserdiodenaufbau mit reduziertem Rauschen**
Laser diode structure with reduced noise
Montage de diodes laser à bruit réduit

(43) Veröffentlichungstag der Anmeldung: 07.09.2011
(73) Patentinhaber: Axetris AG, 6056 Kägiswil (CH)
(72) Erfinder: Willing, Bert, 1807 Blonay (CH); Gaillard, Mathieu, 1004 Lausanne (CH); Manzeneder, Stefan, 6072 Sachseln (DE)
(74) Vertreter: Klocke, Peter

(56) Entgegenhaltungen:
- EP-A2- 0 800 167
- JP-A- 8 043 692
- JP-A- 60 185 231
- JP-A- 2009 260 118
- US-A1- 2006 251 425
- GERGINOV V ET AL: "Diode lasers for fast-beam laser experiments" OPTICS COMMUNICATIONS, NORTH-HOLLAND PUBLISHING CO. AMSTERDAM, NL LNKD- DOI:10.1016/S0030-4018(00)01103-2, Bd. 187, Nr. 1-3, 1. Januar 2001 (2001-01-01), Seiten 219-230, XP004228384 ISSN: 0030-4018

## Beschreibung

Die Erfindung betrifft einen Laserdiodenaufbau zur Erzeugung eines Laserstrahls, vorzugsweise zur Anwendung bei der Gasdetektion. Der Laserdiodenaufbau weist eine in einem abgeschlossenen Gehäuse angeordnete Laserdiode auf, wobei das Gehäuse einen Gehäuseboden, ein Austrittsfenster für den Laserstrahl, elektrische Anschlüsse, eine Temperiereinrichtung für die Laserdiode und ein optisches Element zur Lenkung und/oder Formung des Laserstrahls aufweist, wobei das optische Element mit Abstand zu der Laserdiode positioniert ist. Dabei ist die Temperiereinrichtung auf dem Gehäuseboden angeordnet und trägt die Laserdiode.

Ein derartiger Laserdiodenaufbau kann beispielsweise als schmalbandige Strahlungsquelle in Verbindung mit einem entsprechenden Strahlungsdetektor dazu verwendet werden, um die Konzentration eines bestimmten Gases in einem Gemisch mit anderen Gasen festzustellen. Bei solchen Gassensoren erfolgt der Nachweis des festzustellenden Gases in der Regel durch Anwendung der Absorptionsspektroskopie. Bei dieser Technik wird ein von dem Laserdiodenaufbau erzeugter, auf das zu detektierende Gas in der Wellenlänge abgestimmter Laserstrahl durch das Gasgemisch hindurchgeleitet. Die Wellenlänge des Laserlichtes ist dabei so gewählt, dass das Laserlicht von dem Gas stark absorbiert wird. Der Absorptionsgrad des Laserstrahls wird dabei als Indikator für den Konzentrationswert des zu detektierenden Gases benutzt.

Es ist bekannt, mit einer monomodigen Laserdiode, beispielsweise einer DFB-oder VCSEL-Laserdiode unter Ausnutzung der Abstimmbarkeit der Diode bezüglich ihrer Emissionswellenlänge über die Arbeitstemperatur, Teile der Spektren von zu untersuchenden Gasen abzuscannen und dabei die Gase anhand ihrer charakteristischen Spektrallinien zu detektieren. Üblicherweise wird dabei die Betriebstemperatur der Laserdiode mittels einer thermoelektrischen Temperiereinrichtung, beispielsweise eines kühlenden Peltierelements eingestellt sowie konstant gehalten und die Abstimmung der von der Laserdiode emittierten Laserstrahlung durch Variation des Betriebsstromes der Laserdiode herbeigeführt. Dabei ist es für eine hohe Nachweisempfindlichkeit bei der Verwendung des Laserdiodenaufbaus in der Gassensorik erforderlich, wie sie beispielsweise bei der abstimmbaren Lasergasdetektion (TDLS) benötigt wird, dass die von dem Laserdiodenaufbau erzeugte Laserstrahlung mit möglichst geringen Interferenzerscheinungen aus der Laserdiode austritt. Schon geringfügige Rückreflexionen des Laserlichts des von der Laserdiode ausgehenden Laserstrahls an spiegelnden Flächen des Gehäuses, einer Kollimatorlinse bzw. dem Austrittsfenster des Laserdiodenaufbaus bewirken ein Selfmixing des Laserstrahls und/oder Etalons. Beide Effekte verursachen ein optisches Rauschen, das bei hoch auflösenden Messanordnungen und bei schwachen Gasabsorptionen zu einer Minderung der Signalauflösung führt.

Das Bewegen einer Laserdiode oder eine Kollimationslinse ist aus JP-A-60 185 231 und EP-A-0 800 167 bekannt. Ein Laserdiodenaufban zur Gasdetektion ist aus V. Georginov, Opt. Commun. 187 (2001) 219 bekannt.

Der Erfindung liegt die Aufgabe zugrunde, die Etalons bzw. das Selfmixing einer Laserdiode durch Rückreflexionen innerhalb des Gehäuses des Laserdiodenaufbaus deutlich zu reduzieren bzw. ganz zu eliminieren, um die Messsignalauflösung zu verbessern.

Diese Aufgabe wird erfindungsgemäß durch einen Laserdiodenaufbau mit den Merkmalen des Anspruchs 1 gelöst. Weitere vorteilhafte Ausführungsformen sind den rückbezogenen Unteransprüchen zu entnehmen.

Der Erfindung liegt der Kerngedanke zugrunde, insbesondere die Rückreflexionen von Laserlicht an spiegelnden Flächen von optischen Bauelementen im Gehäuse und von Gehäusewänden des Laserdiodenaufbaus in die Laserapertur der Laserdiode zeitlich zu mitteln. Dies wird dadurch erreicht, dass die optische Weglänge für den Laserstrahl zwischen den reflektierenden Flächen und der Laserapertur mittels eines beweglichen optischen Elementes kontinuierlich zyklisch geringfügig variiert wird. Unter geringfügig wird in diesem Zusammenhang verstanden, dass sich die Weglänge in der Größenordnung der Wellenlänge des Laserlichtes ändert. In dem Strahlengang können außer dem beweglichen optischen Element auch noch nicht bewegliche strahlformende oder strahllenkende Optikelemente angeordnet sein.

Zur zeitlichen Mittelung von zu der Laserapertur rückreflektierten Anteilen des von der Laserdiode erzeugten Laserstrahls weist der erfindungsgemäße Laserdiodenaufbau eine elektrisch steuerbare Wirkeinrichtung zur zyklischen Änderung der Position und/oder der Ausrichtung des optischen Elementes bezüglich der Laserdiode auf. An die Bewegung des optischen Elementes ist eine Änderung der optischen Weglänge zwischen der Laserdiode und dem bewegbaren optischen Element gekoppelt. Der Laserdiodenaufbau kann kollimierte oder divergente Strahlung aussenden. Wenn der Laserdiodenaufbau den Laserstrahl kollimiert, kann die Kollimatorlinse selbst oder ein anderes zwischen der Laserdiode und der Kollimatorlinse angeordnetes, in Position und/oder Ausrichtung bezüglich dem Gehäuse veränderbares optisches Element bewegt werden. Bei einer unbeweglich mit dem Gehäuse verbundenen Kollimatorlinse, die zum Beispiel das Austrittsfenster des Laserdiodenaufbaus bildet, kann das andere optische Element beispielsweise ein Umlenkspiegel sein. Für den Fall, dass der Laserdiodenaufbau divergierende Strahlung aussenden soll, d. h. dass keine Kollimatorlinse vorgesehen ist, kann das bewegbare optische Element mit einem nicht kollimierenden Austrittsfenster zusammenwirken. Die Wirkeinrichtung verändert die optische Weglänge für den Laserstrahl in dem Gehäuse des Laserdiodenaufbaus periodisch oszillierend. Die Oszillation entlang dem Verlauf des Laserstrahls bis zu dem bewegbaren optischen Element erfolgt vorzugsweise asynchron zu der Modulation des Laserstroms der Laserdiode respektive der Wellenlänge des Laserlichtes.

Generell gibt es dabei drei Möglichkeiten, die optische Weglänge zu ändern. Das optische Element kann in Richtung des Strahlengangs bewegt werden, senkrecht dazu oder im Strahlengang gedreht werden. Auch eine Kombination dieser Bewegungsarten ist möglich. Bei der ersten Möglichkeit kann beispielsweise der Abstand der Laserdiode und zu einer Kollimatorlinse verändert werden, indem die Kollimatorlinse entlang ihrer optischen Achse oszillierend bewegt wird. Die Alternative anstatt des optischen Elements die Laserdiode zu bewegen, die von der am Gehäuseboden angeordneten Temperiereinrichtung, üblicherweise einem Peltierelement, getragen ist, ist als problematisch anzusehen. Ein zwischen der Temperiereinrichtung und der Laserdiode beziehungsweise ein zwischen dem Gehäuseboden und der Temperiereinrichtung angeordneter Aktuator zur Bewegung der Laserdiode, beispielsweise in Form eines Piezobauelements, ist der Temperaturstabilisierung der Laserdiode stets abträglich. Bereits geringfügige Änderungen der Temperatur der Laserdiode wirken sich negativ auf die Wellenlängenstabilität und die Qualität des Laserstrahls aus. Daher ist es ungünstig, für die Änderung der optischen Weglänge die Laserdiode zyklisch in dem Gehäuse des Laserdiodenaufbaus zu bewegen, insbesondere deren Abstand zu der Temperiereinrichtung und/oder zu dem Gehäuseboden fortlaufend zu ändern.

In bevorzugten Ausführungsformen der Erfindung ist mit der Wirkeinrichtung der Abstand des optischen Elementes, beispielsweise einer Kollimatorlinse, eines Umlenkspiegels oder eines anderen den Laserstrahl beeinflussenden optischen Elementes zu der Laserdiode beeinflussbar. Zur Bewegung der Kollimatorlinse, des Umlenkspiegels und/oder eines anderen den Laserstrahl im Strahlprofil oder in der Richtung verändernden optischen Elements weist die Wirkeinrichtung vorzugsweise einen elektrischen Aktuator auf, der mit dem bewegbaren optischen Element sowie mit dem Gehäuse, vorzugsweise dem Gehäuseboden verbunden ist. Dabei ist eine bewegbare Kollimatorlinse als optisches Element vorzugsweise als Mikrolinse ausgebildet. Für den Fall, dass die Kollimatorlinse das Austrittsfenster bildet, ist der Umlenkspiegel vorzugsweise als Mikrospiegel vorgesehen. Die Mikrolinse bzw. der Mikrospiegel können auf einem mit dem Aktuator verbundenen Träger oder direkt auf dem Aktuator angeordnet sein. Es hat sich als zweckmäßig erwiesen, einen Träger mit Ausleger zu verwenden, wobei der Träger mit dem Aktuator fest verbunden und die Mikrolinse oder der Mikrospiegel auf dem seitlich vom Aktuator abstehenden Ausleger angeordnet ist.

Mittels dem Aktuator ist günstigerweise eine Translationsbewegung, eine Schwenkbewegung oder eine Rotationsbewegung des optischen Elementes ausführbar. Abhängig von der Wirkrichtung des Aktuators und dessen Anbindungsart und Anbindungsrichtung an das optische Element kann dieses durch den Aktuator in ihrer Stellung bezüglich der optischen Achse der Laserapertur der Laserdiode beliebig zyklisch bewegt werden. Das optische Element kann dabei unter Beibehaltung seines Neigungswinkels bezüglich dem von der Laserapertur ausgehenden Laserstrahl beispielsweise nur längs oder quer dem optischen Pfad des Laserdiodenaufbaus verschoben oder um eine oder mehrere räumliche Achsen geneigt werden. Auch eine Kombination von einer oder mehreren Neigungsrichtungen mit einer oder mehreren Translationsrichtungen lässt sich mit der Wirkeinrichtung realisieren.

Vorzugsweise wird als Aktuator ein Mikroaktuator in Form eines Piezoschwingelements, eines elektromechanischen Antriebs bzw. einer elektrostatischen oder eine thermischen Stelleinrichtung verwendet. Bei allen möglichen Ausführungsformen des erfindungsgemäßen Laserdiodenaufbaus weist die Wirkeinrichtung zudem eine Steuerung auf, mittels der der Aktuator mit einem Gleichspannungsanteil und/oder einem Wechselspannungsanteil beaufschlagbar ist. Es wird besonders favorisiert, zur Ausrichtung des Laserstrahls auf den Strahlungsdetektor den Gleichspannungsanteil der Aktuatorsteuerung zu benutzen. Dabei kann die Steuerung die Amplitude, die Frequenz und/oder die Kurvenform des Wechselspannungsanteils für eine optimale zeitliche Mittelung des rückreflektierten Laserlichtes variieren.

Beispielsweise kann für die zeitliche Mittelung der Rückreflexionen von Laserlicht mittels einer bewegbaren Kollimatorlinse eine Mikrolinse aus Silizium vorgesehen sein, die an dem Aktuator so angebracht ist, dass die Laserapertur in der Fokalebene der Mikrolinse liegt. Die kollimierende Mikrolinse wird dabei so angeordnet, dass sie einige hundert Mikrometer in Erstreckungsrichtung des Laserstrahls (z-Richtung) von der Laserapertur der Laserdiode, beispielsweise der Laserapertur eines VCSELs entfernt ist. Der Aktuator wird zur Mittelung von der Steuerung der Wirkeinrichtung mit einer Wechselspannung betrieben, so dass die Position der Kollimatorlinse über der Laserapertur in z-Richtung oszilliert. Die Frequenz der Wechselspannung ist genügend hoch gewählt, so dass jeder Messpunkt über ausreichend viele Positionen gemittelt wird. Durch diese Maßnahme werden die Etalons bzw. Selfmixing-Effekte, die durch die Grenzfläche der Mikrolinse entstehen, effizient gemittelt.

In einer einfachen Ausführungsform kann als Aktuator beispielsweise ein Piezoschwingelement verwendet sein, das seine Bauhöhe durch eine angelegte elektrische Spannung verändert. Darüber hinaus ist es vorteilhaft, die Laserapertur zwar in der Fokalebene der Kollimatorlinse anzuordnen, jedoch nicht in den Fokus der Linse selbst. Ein seitlicher Versatz der optischen Achse der Kollimatorlinse zu der optischen Achse der Laserapertur von 30 bis 50 µm hat sich in der Praxis als optimal erwiesen. Weiterhin ist es von Vorteil, die Aktuatorlinse so an dem Aktuator anzubringen, dass die Fokalebene der Kollimatorlinse nicht vertikal zur Strahlrichtung des Laserstrahls ist, sondern einen Neigungswinkel von etwa 10 bis 30° gegenüber dem Laserstrahl aufweist.

Prinzipiell können bei dem erfindungsgemäßen Laserdiodenaufbau an die Stelle der Kollimatorlinse beliebige andere Strahlformungselemente treten, die die gleiche Wirkung zeigen. Solche Strahlformungselemente können beispielsweise kollimierende Mikrolinsen aus beliebigen Materialien, kollimierende Spiegel oder kollimierende GRIN-Linsen sein. Als kollimierende Spiegel können beispielsweise Konvexspiegel, Parabolspiegel, off-axis Parabolspiegel oder elliptische Spiegel oder dergleichen verwendet werden. Auch können als bewegbares optisches Element oder als feststehendes Optikelement diffraktive optische Bauelemente eingesetzt werden.

Zur zeitlichen Mittelung der Rückreflexionen von Laserlicht zu der Laserapertur der Laserdiode kann auch die Achse des Laserstrahls bezüglich der optischen Achse der Kollimatorlinse kontinuierlich hin- und hergeschwenkt werden. Hierdurch ergeben sich ständig unterschiedliche Weglängen für die Rückreflexionen, wodurch die damit verbundenen Interferenzeffekte effektiv gemittelt werden. Um die Strahlachse des Laserstrahls kontinuierlich oszillierend zu schwenken, kann beispielsweise der bewegliche Umlenkspiegel so an dem Aktuator angebracht werden, dass der Laserstrahl zunächst auf die Spiegeloberfläche trifft, bevor er die Oberfläche der Kollimatorlinse erreicht. Um die Baugröße des Laserdiodenaufbaus klein zu halten, kann beispielweise ein so genannter Mikrospiegel mit einer Spiegeloberfläche von wenigen Quadratmillimetern verwendet werden.

Der Umlenkspiegel kann dabei um mindestens eine Achse geschwenkt werden. Typischerweise wird ein solcher Mikrospiegel mit einer Gleichspannung betrieben, der eine Wechselspannung überlagert ist. Mittels der Gleichspannung kann die Nulllage des Mikrospiegels definiert werden, während die Wechselspannung dazu dient, den Mikrospiegel kontinuierlich um die Nulllage hin und her zu schwenken. Da auf einer optischen Weglänge des Laserstrahls von ca. 1 bis 2 mm Wegunterschiede von ca. 1 bis 2 µm zur effektiven zeitlichen Mittelung der Rückreflexionen erzeugt werden müssen, reichen hierfür sehr kleine Auslenkungen des Umlenkspiegels um die Nulllage aus. Durch das Schwenken der Achse des Laserstrahls werden diese Wegunterschiede für alle möglichen Reflexionsflächen ständig erzeugt, so dass eine solche Anordnung eine effiziente Mittelung über alle auftretenden optischen Interferenzen ermöglicht. Störende Effekte durch Etalons oder Selfmixing werden dadurch weitgehend unterdrückt. Die Einstellung der Nulllage des Laserstrahls durch den Gleichspannungsanteil, mit dem der Mikrospiegel bewegt wird, lässt sich darüber hinaus auch zur automatischen Justierung des Laserstrahls auf einen Fotodetektor verwenden.

Dazu ist ein Mikrospiegel von Vorteil, der sich mittels dem Aktuator um zwei Achsen auslenken lässt: Ein derartiger Umlenkspiegel ist dabei offenbar einem einachsig auslenkbaren Spiegel deutlich überlegen.

Vorzugsweise sind bei allen möglichen Ausführungsformen des erfindungsgemäßen Laserdiodenaufbaus das Austrittsfenster, die Kollimatorlinse und/oder der Umlenkspiegel zu der Laserdiode derart angeordnet, dass deren optische Achsen gegenüber der optischen Achse der Laserapertur der Laserdiode geneigt sind. Dabei ist der Neigungswinkel so gewählt, dass an dem Austrittsfenster, der Kollimatorlinse bzw. dem Umlenkspiegel auftretende Rückreflexionen die Laserapertur verfehlen.

Der vorgeschlagene Laserdiodenaufbau ist nicht auf VCSELs beschränkt, sondern kann sinngemäß DFBs und beliebig andere Diodenlaser verwendet werden. Insbesondere kann ein solcher Laserdiodenaufbau die Kombination einer beweglichen Kollimatorlinse mit einem beweglichen Umlenkspiegel beinhalten.

Nachfolgend wird die Erfindung anhand von drei in der Zeichnung dargestellten Ausführungsbeispielen näher erläutert. Weitere Merkmale der Erfindung ergeben sich aus der folgenden Beschreibung der Ausführungsbeispiele der Erfindung in Verbindung mit den Ansprüchen und den Figuren der beigefügten Zeichnung. Die einzelnen Merkmale können dabei für sich allein oder zu mehreren bei unterschiedlichen Ausführungsformen der Erfindung verwirklicht sein.

Es zeigen:
- Figur 1: einen ersten erfindungsgemäßen Laserdiodenaufbau mit einer parallel zu der Laserapertur der Laserdiode angeordneten bewegli- chen Mikrolinse;
- Figur 2: einen zweiten erfindungsgemäßen Laserdiodenaufbau mit einem geneigt zu der Laserapertur angeordneten beweglichen Mikrolinse; und
- Figur 3: einen dritten erfindungsgemäßen Laserdiodenaufbau mit einem geneigt zur Laserapertur der Laserdiode angeordneten beweglichen Mikrospiegel.

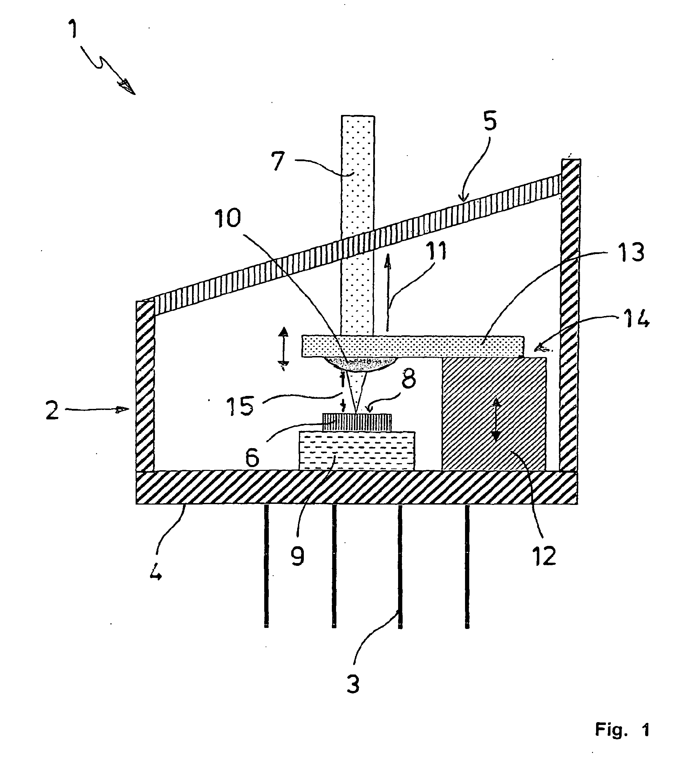

Figur 1 zeigt ein erstes Ausführungsbeispiel eines erfindungsgemäßen Laserdiodenaufbaus 1, mit einem hermetisch abgeschlossenen Gehäuse 2, das eine Anzahl von elektrischen Anschlüssen 3 an einem Gehäuseboden 4 des Gehäuses 2 aufweist. Dem Gehäuseboden 4 gegenüberliegend ist ein Austrittsfenster 5 zum Austritt eines von einer Laserdiode 6 emittierten Laserstrahls 7 aus dem Gehäuse 2 vorgesehen. Das Austrittsfenster 5 erstreckt sich schräg zu dem Gehäuseboden 4 des Gehäuses 2 und zu einer Laserapertur 8 der Laserdiode 6. Die Laserdiode 6 ist auf einer Temperiereinrichtung 9 befestigt, die von einem Peltierelement gebildet ist. Das Peltierelement 9 ist auf dem Gehäuseboden 4 angeordnet und trägt die Laserdiode 6 auf einer kalten Flachseite. Mit der gegenüberliegenden warmen Flachseite ist das Peltierelement 9 mit dem Gehäuseboden 4 gut wärmeleitend verbunden. Zusätzlich kann neben der Laserdiode 6 auf dem Peltierelement 9 noch ein in der Zeichnung nicht dargestellter Thermistor als Temperatursensor angeordnet sein, der den Betriebsstrom des Peltierlelementes regelt.

Zwischen der Laserdiode 6 und dem Austrittsfenster 5 des Laserdiodenaufbaus 1 ist eine Kollimatorlinse 10 die Laserapertur 8 überdeckend zur Kollimierung des Laserstrahls 7 angeordnet. Die Kollimatorlinse 10 ist parallel zu der Laserapertur 8 der Laserdiode 6 mit Abstand angeordnet und als Mikrolinse ausgeführt. Der Abstand zu der Laserapertur 8 beträgt ca. 2 mm. Die Mikrolinse 10 ist in und entgegen der Erstreckungsrichtung 11 des Laserstrahls 7 in Abhängigkeit von der Wellenlänge des Laserlichtes um typisch 1 bis 3 µm mittels einem Aktuator 12 in Form eines Piezoschwingelementes bewegbar. Das Piezoschwingelement 12 ist auf dem Gehäuseboden 4 neben dem Peltierelement 9 angeordnet, wobei die Kollimatorlinse 10 von einem von dem Piezoschwingelement 12 seitlich abstehenden Ausleger 13 getragen ist. Die Mikrolinse 10 ist typischerweise quer zu der Laserapertur 8 und damit zum Laserstrahl 7 um etwa 30 bis 50 µm versetzt. Der Versatz, der in der Zeichnung nicht deutlich zu erkennen ist, bewirkt, dass mögliche parallel zu dem emittierten Laserstrahl 7 auftretende Rückreflexionen des Laserstrahls 7 von der Mikrolinse 10 die Laserapertur 8 verfehlen.

Der Aktuator 12 bildet zusammen mit dem Ausleger 13 eine elektrisch steuerbare Wirkeinrichtung 14, mit der eine optische Weglänge 15 zwischen der Kollimatorlinse 10 und der Laserdiode 6 kontinuierlich mittels einer in der Zeichnung nicht dargestellten Steuerung zyklisch änderbar ist. Dabei kann die sich zeitlich fortlaufend ändernde Position der Kollimatorlinse 10 von verschiedenen Arten der Auslenkung bestimmt sein. Die Steuerung kann den Aktuator 12 beispielsweise mit einem sägezahnförmigen, sinoidalen, stochastischen oder gaußverteilungs-ähnlichen Ansteuerungssignal beliebiger Amplitude bzw. beliebiger Frequenz beaufschlagen.

Um außerdem von dem Austrittsfenster 5 des Gehäuses 2 ausgehende störende Rückreflexionen zu der Laserapertur 8 der Laserdiode 6 zuverlässig zu verhindern, ist das Austrittsfenster 5 gegenüber der Kollimatorlinse 10 und der Laserapertur 8 geneigt an dem Gehäuse 2 des Laserdiodenaufbaus angeordnet. Von dem Austrittsfenster 5 reflektierte Anteile des Laserstrahls 7 verfehlen somit die Kollimatorlinse 10 und treffen nicht auf die Laserapertur 8 auf. Das Selfmixing wird damit zuverlässig verhindert.

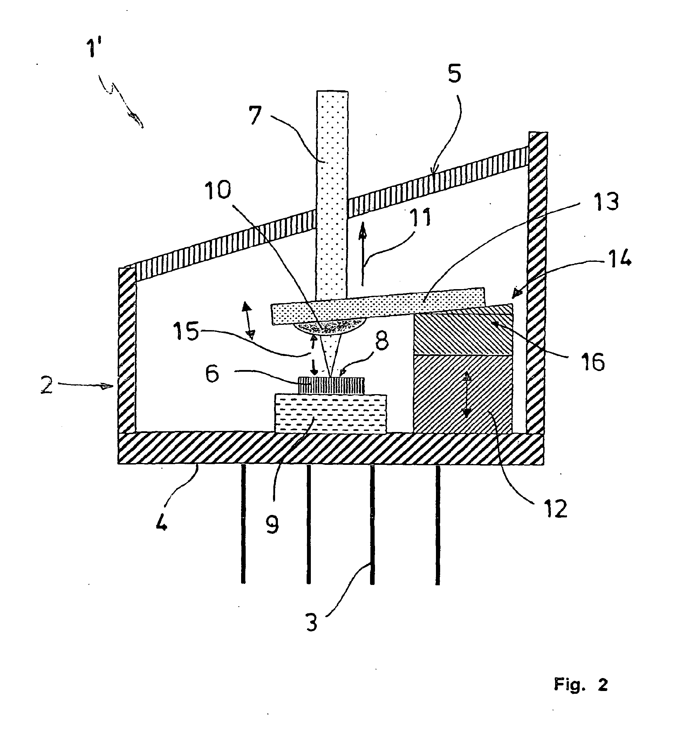

Figur 2 zeigt ein dem ersten Ausführungsbeispiel der Erfindung ähnliches zweites Ausführungsbeispiel. Der in der Figur 2 dargestellte erfindungsgemäße Laserdiodenaufbau 1' unterscheidet sich von dem in der Figur 1 gezeigten Laserdiodenaufbau 1 lediglich durch die Winkellage der Kollimatorlinse 10 gegenüber dem Laserstrahl 7. Bei dem Laserdiodenaufbau 1 erstreckt sich die Kollimatorlinse 10 orthogonal zu dem Laserstrahl 7, im Laserdiodenaufbau 1' mit einem vom 90° abweichenden Winkel (Kippwinkel). Der Kippwinkel beträgt vorzugsweise zwischen 10 und 30°. Durch die gegenüber der Erstreckungsrichtung 11 des Laserstrahls 7 geneigte Kollimatorlinse 10 werden von der Kollimatorlinse 10 reflektierte Anteile des Laserstrahls 7 an der Laserapertur 8 der Laserdiode 6 vorbeigelenkt. Durch diese Maßnahme werden die durch die Reflektion des Laserlichtes an den Grenzflächen der Kollimatorlinse 10 bedingten Selfmixing-effekte deutlich verringert und die zeitliche Mittelung der sonstigen vorkommenden Etalons wesentlich effizienter.

Um den Ausleger 13 gegenüber dem Laserstrahl 7 zu neigen, ist zwischen dem Aktuator 12 und dem Ausleger 13 ein Neigungskeil 16 angeordnet, der in diesem Fall zusammen mit dem Ausleger 13 und dem Aktuator 12 die Wirkeinrichtung 14 bildet. Die Kollimatorlinse 10 ist parallel zu dem Ausleger 13 angeordnet und erstreckt sich somit quer zu dem Laserstrahl 7. Für einen ähnlichen Abstand zwischen der Kollimatorlinse 10 und der Laserapertur 8 ist der Aktuator 12 niedriger als bei dem in der ersten Figur 1 abgebildeten Laserdiodenaufbau 1 ausgeführt. Mittels dem Aktuator 12 kann die Kollimatorlinse 10 mit gleichbleibendem Kippwinkel gegenüber dem Laserstrahl 7 oszillierend bezüglich der Laserdiode 6 hin und her bewegt werden.

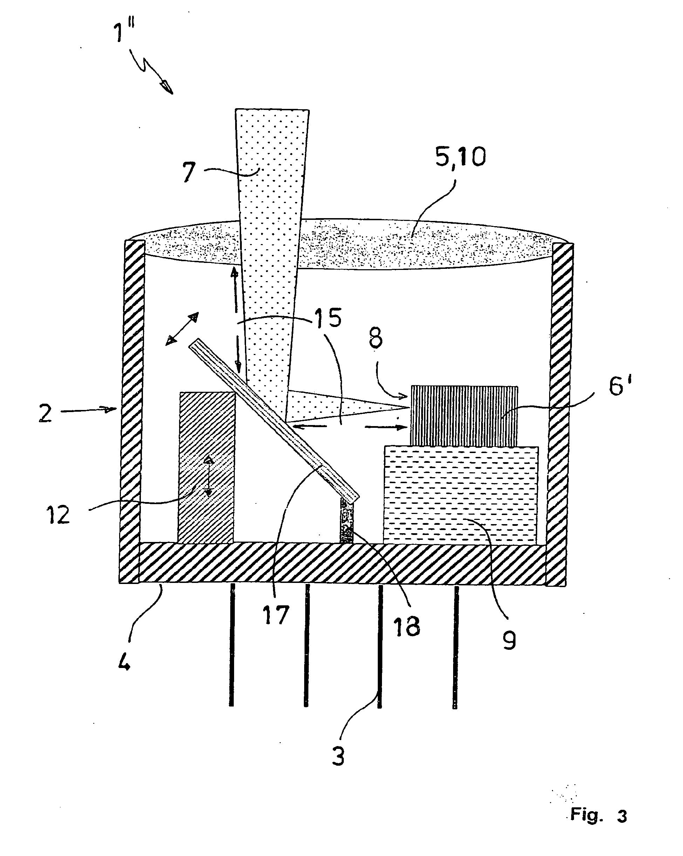

Figur 3 zeigt ein drittes Ausführungsbeispiel des erfindungsgemäßen Laser diodenaufbaus. Bei dem dargestellten Laserdiodenaufbau 1" bildet die Kollimatorlinse 10 gleichzeitig das Austrittsfenster 5, das in diesem Fall parallel zu dem Gehäuseboden 4 des Gehäuses 2 angeordnet ist. Die Laserdiode 6' ist wie die Laserdioden 6 bei den in den Figuren 1, 2 gezeigten Laserdiodenaufbauten 1, 1' von einer Temperiereinrichtung 9 getragen, die auf dem Gehäuseboden 4 außermittig angeordnet ist. Die Laserdiode 6' weist gegenüber den in den Laserdiodenaufbauten 1, 1' verwendeten Laserdioden 6 eine Laserapertur 8 auf, die seitlich an der Laserdiode 6' vorgesehen ist. Nach dem Austritt aus der Laserapertur 8 wird der Laserstrahl 7 von einem Umlenkspiegel 17 in Form eines Mikrospiegels in Richtung der Kollimatorlinse 10 umgelenkt.

Der Mikrospiegel 17 ist zum einen schwenkbeweglich mit einem Halter 18 verbunden, der neben der Temperatureinrichtung 9 an dem Gehäuseboden 4 befestigt ist, und zum anderen entfernt von dem Halter 18 mit dem Aktuator 12, der ebenfalls auf dem Gehäuseboden 4 angeordnet ist. Mittels dem Aktuator 12 kann die Neigung des Umlenkspiegels 17 gegenüber der Laserapertur 8 und damit gegenüber dem Laserstrahl 7 sowie gegenüber der das Austrittsfenster 5 bildenden Kollimatorlinse 10 kontinuierlich zyklisch geschwenkt werden. Der Aktuator 12 bildet zusammen mit dem Halter 18 die elektrisch steuerbare Wirkeinrichtung 14, mit der eine optische Weglänge 15 zwischen der Kollimatorlinse 10 und der Laserdiode 6' kontinuierlich zyklisch änderbar ist. Die Ansteuerung des Aktuators 12 erfolgt wie bei den beiden vorstehend beschriebenen Ausführungsbeispielen durch eine in der Zeichnung nicht dargestellte Steuerung der Wirkeinrichtung 14, die den Aktuator 12 in ähnlicher Weise wie bei den Laserdiodenaufbauten 1, 1' mit einer Wechselspannung ansteuert. Die Wechselspannung kann dabei auf eine Gleichspannung aufmoduliert sein, mit der die Nulllage des Mikrospiegels 17 definiert werden kann. Durch das Schwenken des Laserstrahls 7 mittels dem Mikrospiegel 17 gegenüber der Kollimatorlinse 10 werden Wegunterschiede des Laserstrahls 7 für alle möglichen Reflexionsflächen in dem Gehäuse 2 des Laserdiodenaufbaus 1" erzeugt, so dass eine effiziente Mittelung über alle auftretenden optischen Interferenzen erreicht wird. Störende Effekte durch Etalons oder Selfmixing werden dadurch weitgehend unterdrückt.

## Patentansprüche

1. Laserdiodenaufbau (1, 1', 1") zur Erzeugung eines Laserstrahls (7), konfiguriert zur Anwendung bei der Gasdetektion, mit einer in einem abgeschlossenen Gehäuse (2) angeordneten Laserdiode (6, 6'), wobei das Gehäuse (2) einen Gehäuseboden (4), ein Austrittsfenster (5) für den Laserstrahl (7), elektrische Anschlüsse (3), ein Peltierelement (9) als aktive Temperiereinrichtung (9) für die Laserdiode (6, 6') und ein optisches Element (10) zur Lenkung und/oder Formung des Laserstrahls (7) aufweist, wobei das Peltierelement (9) auf dem Gehäuseboden (4) angeordnet ist und die Laserdiode (6, 6') trägt und wobei das optische Element (10) mit Abstand zu der Laserdiode (6, 6') positioniert ist, **dadurch gekennzeichnet, dass** der Laserdiodenaufbau (1, 1', 1") eine neben dem Peltierelement (9) auf dem Gehäuseboden (4) angeordnete elektrisch steuerbare Wirkeinrichtung (14) konfiguriert zur kontinuierlichen zyklischen Änderung der Position und/oder Ausrichtung des optischen Elementes (10) zu der Laserdiode (6, 6') aufweist, wobei sich die optische Weglänge zwischen der Laserdiode (6, 6') und dem optischen Element (10) durch die Bewegung des optischen Elementes (10) periodisch oszillierend in der Größenordnung der Wellenlänge des Laserlichtes verändert.

2. Laserdiodenaufbau nach Anspruch 1, **dadurch gekennzeichnet, dass** das optische Element (10) eine Linse zur Kollimierung des Laserstrahls (7) der Laserdiode (6, 6') ist.

3. Laserdiodenaufbau nach Anspruch 1, **dadurch gekennzeichnet, dass** das optische Element (10) eine diffraktives optisches Element ist.

4. Laserdiodenaufbau nach Anspruch 1, **dadurch gekennzeichnet, dass** das optische Element (10) ein Umlenkspiegel (17) zur Lenkung des Laserstrahls (7) der Laserdiode (6, 6') ist.

5. Laserdiodenaufbau nach einem der vorstehenden Ansprüche, **dadurch gekennzeichnet, dass** die Wirkeinrichtung (14) einen elektrischen Aktuator (12) aufweist, der das optische Element (10) mit dem Gehäuse (2), vorzugsweise dem Gehäuseboden (4), verbindet.

6. Laserdiodenaufbau nach Anspruch 5, **dadurch gekennzeichnet, dass** mittels dem Aktuator (12) eine Translationsbewegung, eine Schwenkbewegung oder eine Rotationsbewegung des optischen Elements (10) ausführbar ist.

7. Laserdiodenaufbau nach einem der vorstehenden Ansprüche, **dadurch gekennzeichnet, dass** der Aktuator (12) mittels einer Steuerung der Wirkeinrichtung (14) mit einem Gleichspannungsanteil und/oder einem Wechselspannungsanteil beaufschlagbar ist.

8. Laserdiodenaufbau nach Anspruch 7, **dadurch gekennzeichnet, dass** die Steuerung die Amplitude, die Frequenz und/oder die Kurvenform des Wechselspannungsanteils variiert.

9. Laserdiodenaufbau nach einem der vorstehenden Ansprüche 5 bis 7, **dadurch gekennzeichnet, dass** der Aktuator (12) ein Mikroaktuator, vorzugsweise ein Piezoschwingelement, ein elektromechanischer Antrieb, eine elektrostatische oder eine thermische Stelleinrichtung ist.

10. Laserdiodenaufbau nach einem der vorstehenden Ansprüche, **dadurch gekennzeichnet, dass** das Austrittsfenster (5), die Kollimatorlinse (10) und/oder der Umlenkspiegel (17) optische Achsen aufweisen, die gegenüber einer optischen Achse der Laserapertur (8) der Laserdiode (6, 6') geneigt sind.

## Claims

1. Laser diode structure (1, 1', 1") for generating a laser beam (7), preferably for application in gas detection, with a laser diode (6, 6') arranged in a closed housing (2), with the housing (2) comprising a housing bottom (4), an exit window (5) for the laser beam (7), electrical connections (3), a Peltier element (9) as an active temperature control device (9) for the laser diode (6, 6'), and an optical element (10) for guiding and/or shaping the laser beam (7), with the Peltier element (9) being arranged on the housing bottom (4) and carrying the laser diode (6, 6'), and with the optical element (10) positioned at a distance from the laser diode (6, 6'), **characterized in that** the laser diode structure (1, 1', 1") comprises an electrically controllable power device (14) being configured for continuously cyclically altering the position and/or the alignment of the optical element (10) relative to the laser diode (6, 6'), with the power device (14) being arranged beside the Peltier element (9) on the housing bottom (4), wherein the optical path length between the laser diode (6, 6') and the optical element (10) changes with periodic oscillation in a magnitude of the wavelength of the laser light by the movement the optical element (10).

2. Laser diode structure according to claim 1, **characterized in that** the optical element (10) is a lens for collimating the laser beam (7) of the laser diode (6, 6').

3. Laser diode structure according to claim 1, **characterized in that** the optical element (10) is a diffractive optical element.

4. Laser diode structure according to claim 1, **characterized in that** the optical element (10) is a deflecting mirror (17) for guiding the laser beam (7) of the laser diode (6, 6').

5. Laser diode structure according to one of the preceding claims, **characterized in that** the power device (14) has an electrical actuator (12) that connects the optical element (10) with the housing (2), preferably with the housing bottom (4).

6. Laser diode structure according to claim 5, **characterized in that** a translational motion, a swiveling motion, or a rotating motion of the optical element (10) can be performed by means of the actuator (12).

7. Laser diode structure according to one of the preceding claims, **characterized in that** a direct voltage portion and/or an alternating voltage portion can be applied to the actuator (12) by means of a control system of the power device (14).

8. Laser diode structure according to one of the preceding claims, **characterized in that** the control system varies the amplitude, the frequency and/or the wave shape of the alternating voltage portion.

9. Laser diode structure according to one of the preceding claims 5 to 7, **characterized in that** the actuator (12) is a microactuator, preferably a piezo-oscillating element an electro-mechanical drive system, an electrostatic or a thermal control device.

10. Laser diode structure according to one of the preceding claims, **characterized in that** the exit window (5) , the collimator lens (10) and/or the deflecting mirror (17) have optical axes that are tilted in relation to an optical axis of the laser aperture (8) of the laser diode (6, 6').

## Revendications

1. Structure à diode laser (1, 1', 1") servant à générer un faisceau laser (7), configuré pour être utilisé dans la détection de gaz, avec une diode laser (6, 6') disposée dans un boîtier fermé (2), le boîtier (2) comportant un fond de boîtier (4), une fenêtre de sortie (5) pour le faisceau laser (7), des raccordements électriques (3), un élément Peltier (9) comme régulateur actif de température pour la diode laser (6, 6') et un élément optique (10) pour diriger et/ou mettre en forme le faisceau laser (7), l'élément Peltier (9) étant disposé sur le fond de boîtier (4) et portant la diode laser (6, 6'), et l'élément optique (10) étant positionné à distance de la diode laser (6, 6'), **caractérisée en ce que** la structure à diode laser (1, 1', 1") comporte un dispositif d'action à commande électrique (14) disposé à côté de l'élément Peltier (9) sur le fond de boîtier (4), configuré pour modifier cycliquement la position et/ou l'orientation de l'élément optique (10) par rapport à la diode laser (6, 6'), la longueur du chemin optique entre la diode laser (6, 6') et l'élément optique (10) variant périodiquement de manière oscillante de l'ordre de grandeur de la longueur d'onde de la lumière laser du fait du mouvement de l'élément optique (10).

2. Structure à diode laser selon la revendication 1, **caractérisée en ce que** l'élément optique (10) est une lentille de collimation du faisceau laser (7) de la diode laser (6, 6').

3. Structure à diode laser selon la revendication 1, **caractérisée en ce que** l'élément optique (10) est un élément optique diffractant.

4. Structure à diode laser selon la revendication 1, **caractérisée en ce que** l'élément optique (10) est un miroir de déviation (17) servant à diriger le faisceau laser (7) de la diode laser (6, 6').

5. Structure à diode laser selon une des revendications précédentes, **caractérisée en ce que** le dispositif d'action (14) comporte un actionneur électrique (12) qui relie l'élément optique (10) au boîtier (2), de préférence au fond de boîtier (4).

6. Structure à diode laser selon la revendication 5, **caractérisée en ce que** l'actionneur (12) permet de réaliser un mouvement de translation, un mouvement de pivotement ou un mouvement de rotation de l'élément optique (10).

7. Structure à diode laser selon une des revendications précédentes, **caractérisée en ce que** l'actionneur (12) peut être soumis à une composante de tension continue et/ou à une composante de tension alternative au moyen d'une commande du dispositif d'action (14).

8. Structure à diode laser selon la revendication 7, **caractérisée en ce que** la commande fait varier l'amplitude, la fréquence et/ou la forme de courbe de la composante de tension alternative.

9. Structure à diode laser selon une des revendications précédentes 5 à 7, **caractérisée en ce que** l'actionneur (12) est un micro-actionneur, de préférence un élément oscillant piézoélectrique, un entraînement électromécanique, un dispositif de positionnement électrostatique ou thermique.

10. Structure à diode laser selon une des revendications précédentes, **caractérisée en ce que** la fenêtre de sortie (5), la lentille de collimation (10) et/ou le miroir de déviation (17) présentent des axes optiques qui sont inclinés par rapport à un axe optique de l'ouverture de laser (8) de la diode laser (6, 6').
